# EUROPEAN PATENT SPECIFICATION

(11) **EP 0 462 563 B1**
(45) Date of publication and mention of the grant of the patent: **27.12.1995**
(21) Application number: 91109954.7
(22) Date of filing: 18.06.1991
(51) Int. Cl.: H01L 21/00

(54) **Treating apparatus for semiconductor**
Behandlungseinrichtung für Halbleiter
Appareil de traitement pour semi-conducteur

(30) Priority: 18.06.1990 JP 159269/90; 29.06.1990 JP 171800/90
(43) Date of publication of application: 27.12.1991
(73) Proprietor: TOKYO ELECTRON LIMITED, Shinjuku-ku, Tokyo (JP)
(72) Inventor: Arai, Izumi, Asahi-ku, Yokohama-shi (JP); Tahara, Yoshifumi, Yamato-shi, Kanagawa-ken (JP); Horiuchi, Takao, Fuchu-shi, Tokyo (JP); Fujisawa, Kunitoshi, Ooita-shi, Ooita-ken (JP); Kojima, Hiroshi 305 Green-Heim-Midoriyama, Tokyo (JP); Aoki, Makoto 101 Verdée-Ichigao, Yokohama-shi (JP)
(74) Representative: Füchsle, Klaus, Dipl.-Ing.

(56) References cited:
- EP-A- 0 171 011
- EP-A- 0 260 150
- US-A- 4 508 161

## Description

This invention relates to a treating apparatus used for manufacturing semiconductor devices according to the preamble of claim 1.

A corresponding apparatus is disclosed in US-4,508,161.

General manufacturing processes of semiconductor devices use various semiconductor devices such as etching devices, ashing devices, ion-implating devices or sputtering devices, which treat semiconductor wafers under a reduced pressure. With such devices, required treatment is given to semiconductor wafers which are normally held on a mounting table in a vacuum or in a reduced pressure atmosphere.

Each of the semiconductor devices is provided with a cooling jacket at the side of the mounting table. A coolant in the cooling jacket cools a semiconductor wafer during the treatment thereof so as to prevent the lowering of uniformity of the treatment of the semiconductor wafers due to temperature rise and change in the physical characteristics of the semiconductor wafers.

In general, small spaces are present between the mounting table and the back surface of the semiconductor wafer. During the treatment of the semiconductor device under a reduced pressure, the pressure in the spaces is lowered. When, therefore, the semiconductor wafers are indirectly cooled by means of the coolant in the cooling jacket, remarkable reduction of heat transfer due to the existence of the pressure-reduced small spaces in a pressure-reduced state causes a problem that the semiconductor wafer cannot effectively be cooled during the treatment.

In order to avoid this problem, gas is filled in the small spaces between the mounting table and the semiconductor wafer in such an amount as it does not hinder heat transfer therebetween, whereby the gas used as a heating medium prevents the lowering of the cooling efficiency.

However, the conventional devices for manufacturing semiconductors are encountered with the problem that the temperature distribution at the central portion and the peripheral portions of the semiconductor wafer is likely to differ from each other.

It is considered that this problem results from the fact that a heating medium gas is introduced only at the central portion of the corresponding semiconductor wafer.

This unevenness of the temperature of the semiconductor wafers presents differences in the treatment conditions, making unstable the quality of the articles to be treated. In an etching treatment, for example, an etching proceeds unevenly, lowering the yield of IC production.

When a dense film is to be formed by means of a plasma CVD process, this process must be carried out in a high vacuum. However, the process under a high vacuum condition is encountered with a serious problem that cooling effect is inevitably lowered.

A further vacuum processing apparatus is disclosed in EP 0260150. This apparatus comprises an electrode having an electrode plate made of aluminium and an inorganic insulative dielectric film covering the entire outer surface of the electrode plate, the electrode being provided with a plurality of gas inlets.

It is the object of the present invention to provide a treating apparatus according to the preamble of claim 1 which prevents extraordinary discharge and having a more uniform pressure distribution between the wafer and the mounting table.

This object is solved by the features of claim 1.

Preferred embodiments are characterised by the sub-claims.

This invention can be fully understood from the following detailed description with reference to the accompanying drawings in which:
Fig. 1 is a cross-sectional view of an etching apparatus according to an embodiment of this invention;
Fig. 2 is an enlarged cross-sectional view of part of the mounting table of the etching apparatus of Fig. 1 and part of a semiconductor wafer incorporated therewith, only one gas inlet being shown.
Fig. 3 is an enlarged cross-sectional view of part of the mounting table of the etching apparatus of Fig. 1 and part of a semiconductor wafer incorporated therewith;
Figs. 4A and 4B are a cross-sectional view and a plan view of the etching apparatus of Fig. 1, respectively;
Fig. 5 is a perspective view showing an etching apparatus comprising a loader-unloader part;
Fig. 6 is a view showing a structure of the etching apparatus shown in Fig. 5;
Fig. 7 is a view showing a plasma etching-ashing apparatus which is a part of the etching device shown in Fig. 5; and
Fig. 8 is a view showing an apparatus having a vacuum vessel inner wall of which is heated.

This invention provides an apparatus having a vacuum vessel, which allows for introduction of a gas into a space defined between an article such as semiconductor wafer or electrode and a base member such as a lower electrode or wall of the vacuum vessel so that good heat transfer attained between an article and a base member cools the article effectively.

A treating apparatus according to an embodiment of this invention is provided with means for maintaining the pressure of a gas introduced in a space between an article to be treated (hereinafter referred to as the "to-be-treated article") and a base member to a constant value. This means enables heat transfer between the to-be-treated article and the base member to be stable and accordingly maintains the temperature of the to-be-treated article within a predetermined range.

Specifically, the heat transfer condition is retained uniformly over the entire surface of the to-be-treated article opposed to the base member by adjusting the gas pressure so that the distance between the to-be-treated article and the base member is kept substantially constant. It is necessary to make constant the distance between the to-be-treated article and the base member because an amount of heat transferred depends on this distance. As a result, the temperature of the to-be-treated article can be maintained to a uniform value.

A treating device according to this embodiment is provided on a base with a plurality of gas inlets in order to make uniform the gas pressure in a space defined between a to-be-treated article and the base member over the whole area of the back surface of a wafer. This arrangement prevents the pressure from being raised only at the gas inlets. Since the heat transfer efficiency or the cooling efficiency between the to-be-treated article and the base member greatly depends on the pressure therebetween, the temperature distribution over the whole area of the to-be-treated article can be made uniform by keeping substantially uniform the pressure in the space between the to-be-treated article and the base member.

The treatment apparatus according to this embodiment has an elastic film made of synthetic resin formed on a surface of a to-be-treated article which is disposed opposed to the article so that the impedance between the to-be-treated article and the base member can be maintained to a constant value. This arrangement prevents extraordinary discharge due to impedance variation or the like and keeps the to-be-treated article from damages caused by the extraordinary discharge.

Various embodiments of this invention applied to an etching device will now be explained with reference to the drawings attached hereto.

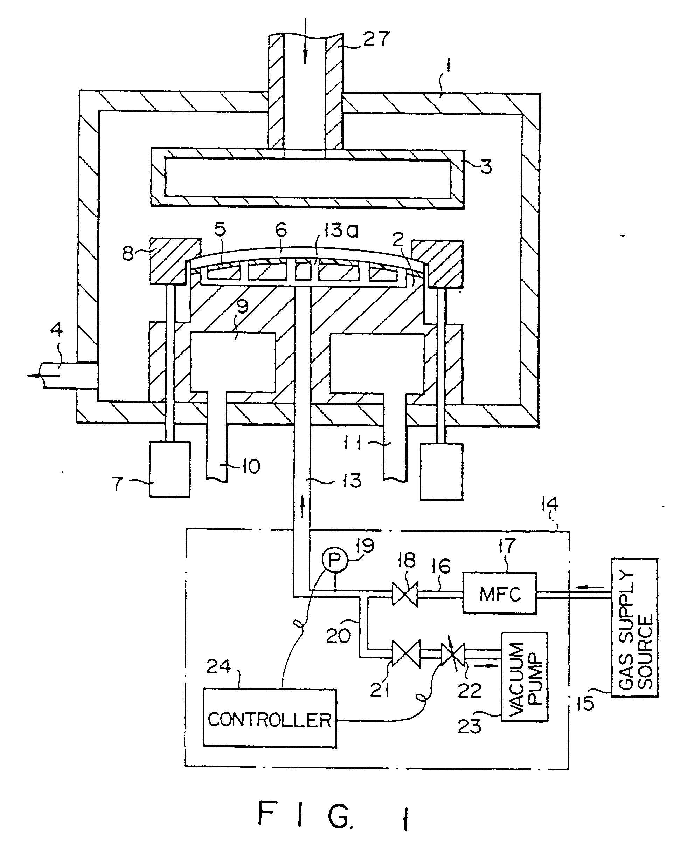

Fig. 1 is a cross-sectional view of an etching device according to an embodiment of this invention. In this figure, a vacuum container 1 contains a mounting table 2 made of aluminum covered with such as an anodized aluminum film and used also as a lower electrode, and an upper electrode 3 disposed opposed thereto. To the vacuum container 1 is connected an exhaust system 4 which can evacuate the interior of the vacuum container 1 up to a predetermined vacuum level, for example, several tens of milli-Torrs to several tens of Torrs (1 Torr = 133 Pa).

An elastic film 5 made of capton (polyimide-based resin) and having a thickness of substantially 25 »m is applied to the upper surface of the mounting table 2 by means of such an acryl-based adhesive having a thickness of 10 to 24 »m. A to-be-treated article such as a semiconductor wafer 6 is loaded on the elastic film 5. The elastic film 5 is so provided as to make constant the impedance between the semiconductor wafer 6 and the mounting table 2 working also as a lower electrode. The impedance between the semiconductor wafer 6 and the mounting table 2 depends on the interval therebetween and thus is likely to be uneven if appropriate means is not provided. The interposition of the elastic film 5 having a high thermal insulation value between the wafer and the mounting table makes the impedance therebetween constant because the impedance is controlled by the elastic film 5 rather than by the distance therebetween.

A clamp ring 8 which is lifted and lowered by means of a driving mechanism 7 such as an air cylinder surrounds the mounting table 2. By pressing the peripheral portion of the semiconductor wafer 6 against the elastic film 5 by means of the clamp ring 8, the semiconductor wafer 6 is held on the mounting table 2 under a predetermined clamp load.

The upper surface of the mounting table 2 is shaped to have substantially the same convex surface (a uniformly distributed load surface) which the semiconductor wafer 6 would be deformed to assume, if the clamp load applied to the periphery of the wafer 6 by clamping the periphery of the semiconductor wafer 6 by means of the clamp ring 8 were considered to be a uniform load.

The mounting table 2 holds the semiconductor wafer 6 and contains a cooling jacket 9 for cooling the wafer 6. An inlet tube 10 and an outlet tube 11 are connected to the cooling jacket 9 so that a coolant such as cooling water circulates through the interior of the cooling jacket 9 via the inlet and outlet tubes 10 and 11.

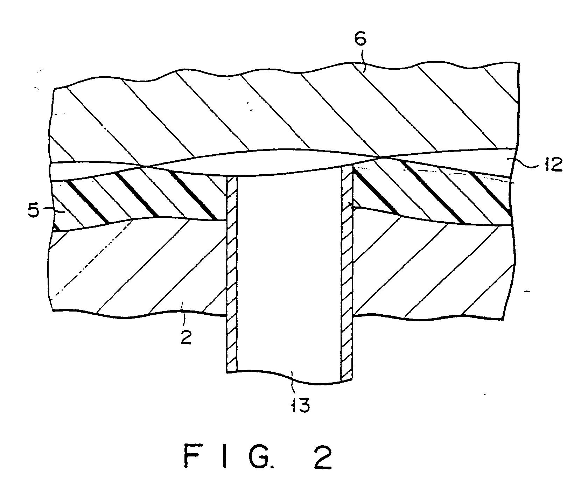

As shown in Fig. 2, minute spaces 12 having a thickness smaller than the surface roughness of the back surface of the semiconductor wafer 6 are inevitably formed between the mounting table 2 and wafer 6. A plurality of gas introducing tubes (only one tube 13 being shown) for introducing into the minute spaces 12 a gas which constitutes a heat-transfer medium for assisting heat transfer between the mounting table 2 and the semiconductor wafer 6 extends through the central portion of the base 2. As shown in Fig. 1, the gas introducing tube 13 is connected to a gas supply source 15 through a pressure controlling mechanism 14 provided externally of the vacuum container 1.

A main pipe 16 in the pressure controlling mechanism 14 is connected by a flow regulator 17 for control of the amount of a gas to be introduced in the spaces, a main opening/closing valve 18 and a pressure gage 19, in turn, as viewed from the gas supply source 15. An auxiliary pipe 20 is branched from the portion of the main pipe 16 between the main opening/closing valve 18 and the pressure gage 19 and is connected to a vacuum pump 23 through an auxiliary opening/closing valve 21 and a pressure control valve 22. The pressure control valve 22 is constructed so that it is controlled by a controller 24 in response to the pressure present in the minute spaces 12 between the elastic film 5 and the semiconductor wafer 6 and measured by the pressure gage 19. The main and auxiliary opening/closing valves 18 and 21 are designed to cooperate with each other.

There will now be explained how the flow regulator 17 controls the pressure in the minute spaces 12.

The amount of the heat-transfer medium gas which is adjusted to a predetermined value by means of the flow regulator 17 is always supplied through the main pipe 16. The pressure in the minute spaces 12 is constantly measured by means of the pressure gage 19. When the pressure value of the pressure gage 19 reaches a predetermined value, the pressure control valve 22 is opened by means of the controller 24, and an excess of the heat-transfer medium gas flows out toward the vacuum pump 23, whereby the pressure in the minute spaces 12 is maintained to a set value. When the heat-transfer medium gas leaks from the minute spaces 12, for example, and thus the pressure in the minute spaces 12 becomes lower than the set value, the pressure control valve 22 is closed and the heat-transfer medium gas is supplied to the minute spaces 12 through the gas introducing tube 13 until the pressure reaches the predetermined value.

Preferably, the pressure of the gas between the base 2 and the semiconductor wafer 6 ist 133 to 2.7x10³ Pa (1 to 20 Torrs).

The upper electrode 3 is connected to a reaction gas supplying tube 27. In the undersurface thereof are formed fine holes, not shown, through which the gas such as argon can flow in the vacuum container 1. The upper electrode 3 and the mounting table 2 constituting the lower electrode are adapted so that plasma is generated between these electrodes. In this embodiment, the mounting table 2 is electrically grounded. Alternatively, a voltage may be applied to the mounting table 2 which is not grounded. Further, voltages having the same or different phases may be applied between the upper and lower electrodes 2 and 3.

The etching operation of the etching apparatus will now be explained.

In Fig. 1, the semiconductor wafer 6 is mounted on the mounting table 2 in the vacuum container 1, the interior of which is evacuated to a predetermined value, and the wafer 6 is held by means of the clamp ring 8 under the predetermined load. A gas constituting a heat-transfer medium is introduced into the minute spaces 12 between the elastic film 5 disposed on the mounting table 2 and the semiconductor wafer 6 according to the following steps.

First, the amount of the heat-transfer medium gas supplied from the gas supply source 15 at a pressure of 0.7 Kg/cm² to 1.0 Kg/cm², for example, is adjusted to a predetermined value such as 0 to 20 SCCM so that the semiconductor wafer 6 is prevented from falling in an abnormal state due to instantaneous introduction of a lot of gas into the minute spaces 12.

The heat-transfer medium gas whose amount is adjusted to the predetermined value is introduced from the gas introducing tube 13 into the minute spaces 12 through the main pipe 16. Since the pressure in the minute spaces 12 has not yet reached the predetermined set value when the gas is introduced, the pressure control valve 22 is in a closed state.

When the pressure generated in the minute spaces 12 and measured by means of the pressure gage 19 reaches the predetermined value, the pressure control gage 22 is opened and consequently permits the heat-transfer medium gas to be continuously supplied at the predetermined flow rate toward the vacuum pump 23 in a state in which the pressure in the minute spaces 12 is maintained to the predetermined value.

Since the peripheral portion of the semiconductor wafer 6 is pressed against the elastic film 5 by means of the clamp ring 8, the heat-transfer medium gas becomes sealed in the minute spaces 12. When the heat-transfer medium gas leaks in the process of treatment and the gas pressure becomes lower than the set value, the pressure control valve 21 is closed and the heat-transfer medium gas is supplied until its pressure reaches the set value. In this way, the pressure in the minute spaces 12 is maintained to the predetermined value, for example, several tens of Torrs.

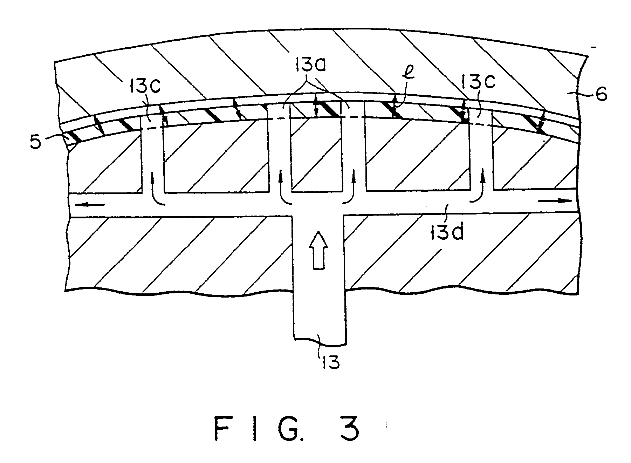

The pressure of the gas introduced into the minute spaces 12 is set to such a predetermined value that the distance ① between the semiconductor wafer 6 and the upper surface of the mounting table 2 is made uniform over the whole area of the semiconductor wafer 6 (see Fig. 3). It is preferred that a concrete set pressure be under the introduced gas pressure at which the heat transfer efficiency is saturated. For example, the set pressure may be the order of 1,3 kPa (10 Torrs) when the saturation occurs at the order of 2,7 kPa (20 Torrs). In this case, a preferable distance ① is 20 to 200 »m.

In the above-mentioned step, plasma is generated between the upper and lower electrodes 3 and 2 by applying a predetermined RF electric power to the upper electrode 3 so that a predetermined etching process is carried out.

In the course of the etching process, the formation of plasma and the etching step raise the temperature of the semiconductor wafer 6. The heat transfer is carried out between the semiconductor wafer 6 and the mounting table 2 through the heat-transfer medium gas introduced into the minute spaces 12 in such a manner that the semiconductor wafer 6 is cooled by cooling water circulating through the cooling jacket 9.

With the etching apparatus according to this embodiment, therefore, the semiconductor wafer 6 and the mounting table 6 are thermally connected to each other through the heat-transfer medium gas introduced into the minute spaces 12 so that the heat-transfer medium gas can provide a fully large heating flux. Further, by selecting, as the set pressure in the minute spaces 12, a pressure at which the distance ① between the semiconductor wafer 6 and the mounting table 2 is substantially uniform over the whole area of the semiconductor wafer 6, the heat transfer efficiency or the cooling efficiency becomes constant over the whole area of the semiconductor wafer 6, whereby the temperature distribution of the semiconductor wafer 6 can be held uniform.

With this etching apparatus, the semiconductor wafer 6 can be well and stably cooled and uniform heat distribution can be maintained. In consequence, stable etching can be effectively carried out.

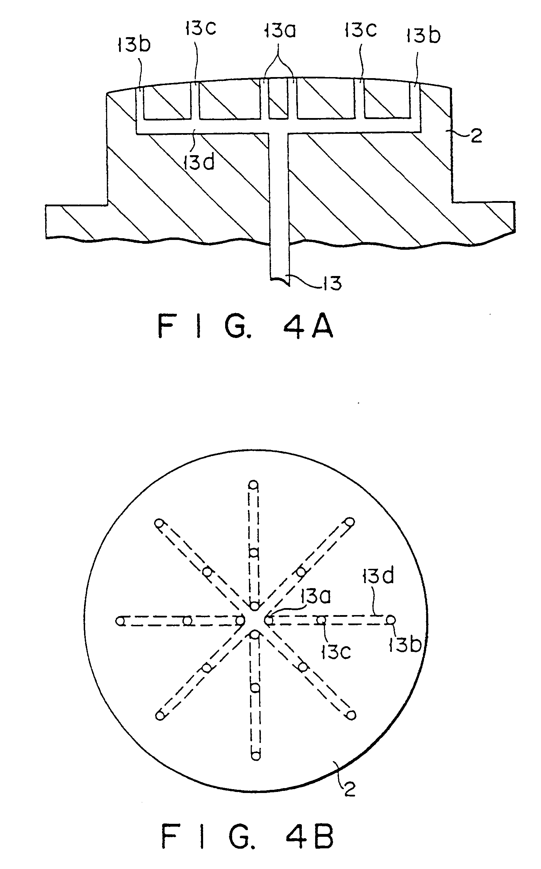

In the etching apparatus shown in Fig. 1, the end portion of a gas introducing tube 13 at the side of the upper surface of a mounting table 2 comprises a plurality of gas inlets 13a to 13c, as shown in Figs. 3, 4A and 4B. More specifically, four gas inlets 13a are arranged at circumferentially equidistantly separated positions in the central portion of the mounting table 2, eight gas inlets 13b are formed at circumferentially equidistantly separated positions in the peripheral portion of the mounting table 2, and eight gas inlets 13c are formed at circumferentially equidistantly separated positions in the intermediate portion of the mounting table 2 between the central portion and the peripheral portion. However, the number of the gas inlets as indicated above is exemplary only and other numbers are possible. The gas inlets 13a to 13b are connected to the gas introducing tube 13 by means of connection tubes 13d extending radially from the central portion of the base 2.

In other words, gas blows out uniformly from the substantially whole area of the semiconductor wafer 6 by providing the gas inlets not only in the central portion of the mounting table 2 but also in the peripheral portion and the intermediate portion thereof. This condition is illustrated in Fig. 3, wherein the gas inlets 13a, 13b and 13c are arranged spaced in the radial directions so that the distance ① defined between the upper surface of the mounting plate 2 and the semiconductor wafer 6 and including the depth of a minute space 12 into which a gas constituting a heat-transfer medium is introduced is rendered substantially uniform over the whole area of the semiconductor wafer 6. The shape of the gas inlets 13a, 13b and 13c may be circular, elliptical, rectangular or the like.

The gas inlets are sized so that no etching irregularity appears and the size is normally 0.2 to 1.5 mm.

Provision of a plurality of gas inlets 13a, 13b and 13c for a heat-transfer medium gas in the mounting table 2 allows for a substantially constant pressure between the semiconductor wafer 6 and the mounting table 2, whereby the distance ① between the upper surface of the mounting table 2 and the semiconductor wafer 6 is made uniform over the whole semiconductor wafer 6. As a result, the semiconductor wafer 6 can be effectively cooled and the temperature distribution can be rendered uniform over the whole area of the semiconductor wafer 6.

The control of the amount of the heat-transfer medium gas introduced into the minute spaces 12 by the pressure enables the semiconductor wafer 6 to be stably cooled during the treatment.

This process facilitates uniform etching over the whole area of the semiconductor wafer 6 and enhances the stability of the etching.

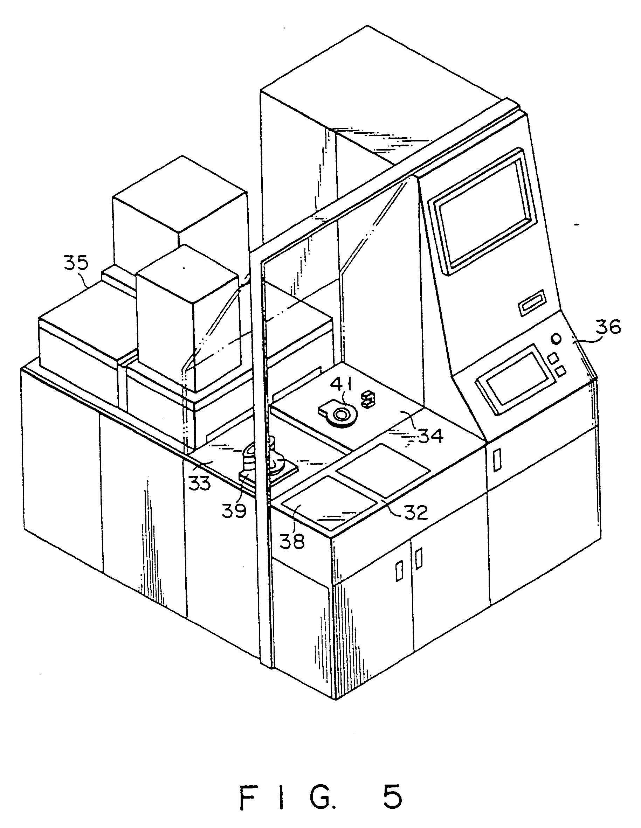

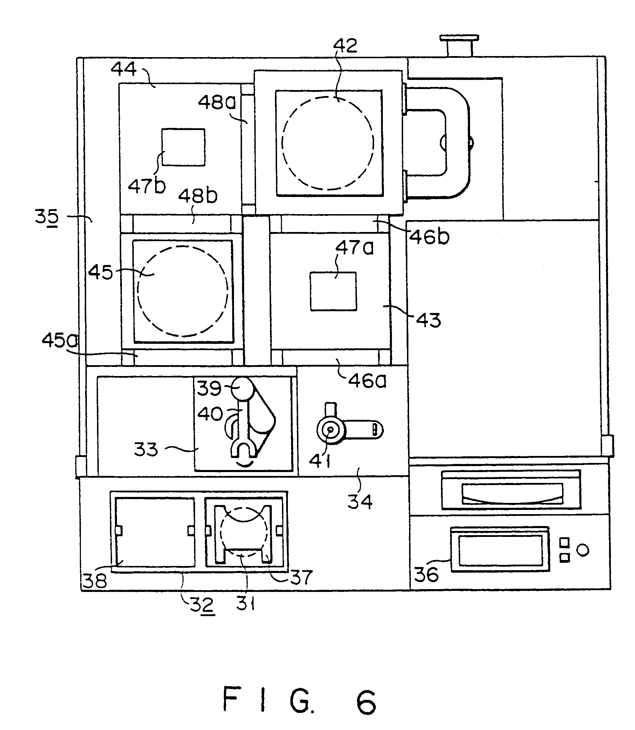

A plasma etching-ashing apparatus according to another embodiment of the invention, which has a loader-unloader section, will now be described with reference to Figs. 5 and 6 which are a perspective view and a plan view, respectively.

As is shown in Figs. 5 and 6, this apparatus comprises a storage section 32 for storing semiconductor wafers, a transport section 33 for transporting wafers into and from the storage section 32, an alignment section 34 for positioning each wafer transported from the storage section 32, a processing section 35 for performing etching-ashing on the wafer positioned by the alignment section 34, and a console section 36 for controlling and monitoring the other sections of the apparatus. The storage section 32, the transporting section 33, and the alignment section 34 constitute the loader-unloader section, which will be described in detail with reference to Fig. 6.

The storage section 32 has a wafer cassette 37 and a cassette table 38. The wafer cassette 37 is mounted on the table 38 and can contain a plurality of wafers (25 wafers, for example), spaced apart in a predetermined direction. The cassette table 38 can be moved up and down by means of an elevator mechanism (not shown). It is desirable that the elevator mechanism be located below the table 38 at all times, so that dust from the mechanism may not enter the wafer cassette 37.

The transport section 33 comprises a multi-joint robot 39 for moving a semiconductor wafer among the storage section 32, the alignment section 34,and the processing section 35. The robot 39 has an arm 40 having a wafer holder (not shown) such as a vacuum-suction mechanism. The arm 40 is made of material not containing heavy metals which would contaminate semiconductor wafers; it is made of, for example, ceramics or quartz glass. The multi-joint robot 39 can rotate around one vertical axis and can move in a horizontal direction.

The alignment section 34 has a vacuum chuck 41. The chuck 41 is comprised of a disk, a ring, and a sensor. The sensor is designed to detect the circumferential edge of a wafer; it is, for example, a transmittance type sensor.

The processing section 35 will now be described in detail. This section comprises a first processing chamber 42, an inlet load-locking chamber 43, an intermediate load-locking chamber 44, and a second processing chamber 45. A semiconductor wafer is moved from the inlet load-locking chamber 43 into the first processing chamber 42, and is subjected to etching in the chamber 42. The second processing chamber 45 is connected to the intermediate load-locking chamber 44. The wafer processed in the chamber 42 is loaded via the intermediate load-locking chamber 44 into the second processing chamber 45, and is subjected to various processed, such as isotropic etching and photoresist-ashing, in the second processing chamber 45.

The inlet load-locking chamber 43 has two doors opposing the alignment section 34 and the first processing chamber 42, respectively. Two mechanisms 46a and 46b are provided for opening and closing these doors, respectively. A handling arm 47a is located near the inlet load-locking chamber 43, and used to transport the a semiconductor wafer from the alignment section 34 to the first processing chamber 42.

The intermediate load-locking chamber 44 also has two doors opposing the first processing chamber 42 and the second processing chamber 45, respectively. Two mechanisms 48a and 48b are provided for opening and closing these doors, respectively. A handling arm 47b is located near the intermediate load-locking chamber 44, and used for transporting the a semiconductor wafer from the first processing chamber 42 to the second processing chamber 45.

The load-locking chambers 43 and 44 are connected to vacuum evacuation means, such as a rotary pump, and also to a purge mechanism for introducing an inert gas, such as nitrogen gas, into the chambers 43 and 44.

The first processing chamber 42 is substantially a hollow cylinder. It is made of, for example, aluminum, and its inner and outer surfaces are anodized aluminum-coated. The chamber 42 has an internal mechanism and and a gas-introducing mechanism which are identical to those of the etching apparatus illustrated in Fig. 1.

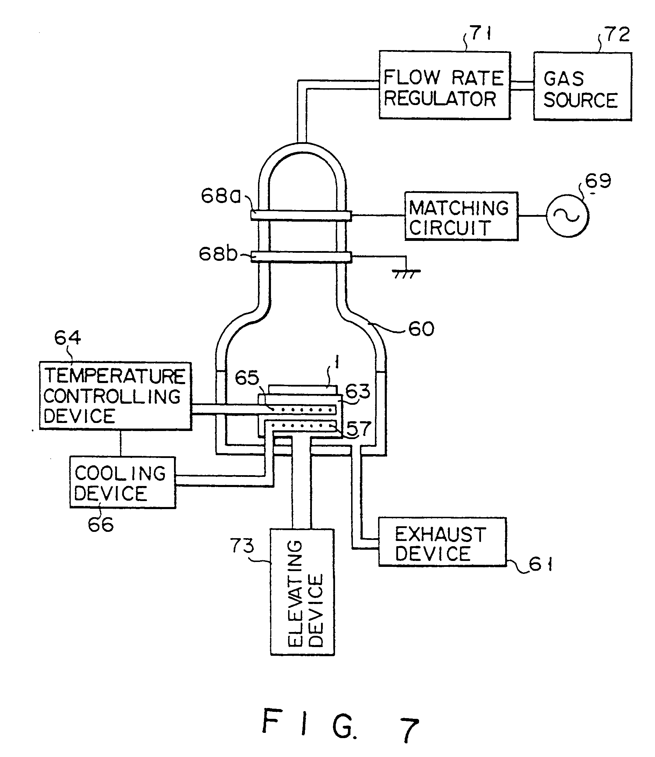

The second processing chamber 45 will be described with reference to Fig. 7. As is shown in this figure, the chamber 45 comprises a processing vessel 60 which is substantially a hollow cylinder. A pair of parallel plate-shaped electrodes 68a and 68b are located in the upper portion of the vessel 60, the electrode 68a being placed above the electrode 68b. The upper electrode 68a is connected to a matching circuit, which in turn is connected to a high-frequency power supply 69 for supplying a 13.56MHz current. The lower electrode 68b is connected to the ground.

A wafer table 63 is located within the vessel 60, for holding a semiconductor wafer by suction force. Embedded in the table 63 are a heater 65 and a coolingwater pipe 57. The heater 65 is controlled by a temperature control device 64 arranged outside the vessel 60. The pipe 57 is connected to a cooling device 66 located outside the vessel 60. The wafer table 63 can be moved up and down by means of an elevator mechanism 73 located outside the vessel 60.

The top of the vessel 60 is connected to a gas-flow adjusting device 71, which in turn is coupled to a treatment gas source 72. The bottom of the vessel 60 has an outlet port (not shown). The treatment gas as supplied from the gas-flow adjusting device 71 flows downwards, is applied onto the wafer 1 mounted on the table 63, further flows along the circumferential surface of the table 63, and flows from the vessel 60 through the outlet port. A purge-gas source (not shown) is coupled to the bottom of the vessel 60, for introducing purge gas upwards into the vessel 60.

The console section 36, which is designed to control the other sections and monitor the condition of the wafer being processed, comprises a control unit, a memory unit, and an input-output unit. The control unit is a micro-controller, which executes programs of, for example, C language.

Explanation has been made to the embodiments in which this invention is applied to the etching apparatus. However, this invention is applicable to not only etching apparatus but also other devices for manufacturing semiconductor devices operated under reduced pressure such as an ashing apparatus, ion-implanting apparatus, sputtering apparatus, ion generating or the like. These other apparatuses have the same effect as the etching apparatus. Articles to be treated are not limited to semiconductors but may be articles made of amorphous material Si on which a TFT circuit constituting a circuit for driving liquid crystal elements is formed.

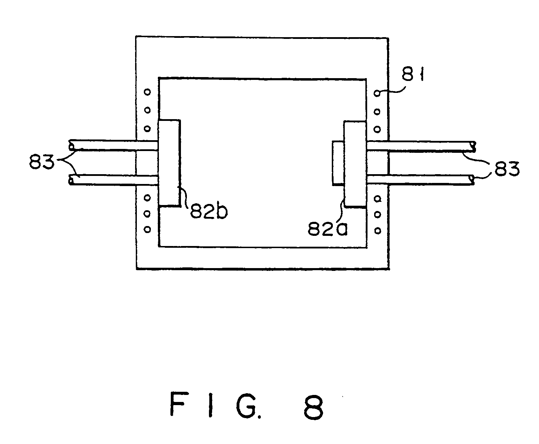

In the embodiments described above, the workpiece is cooled uniformly. Nevertheless, the present invention can be applied to a processing apparatus which heats a workpiece uniformly. More specifically, as is shown in Fig. 8, a heater 81 heats the inner surface of a vessel to prevent a reaction product from sticking the inner surface of the vessel, and also heats electrodes 82a and 82b to prevent the reaction product from sticking these electrodes. To heat either electrode uniformly, gas is applied into the gap between the electrode and the inner surface of the vessel.

As explained above, the treatment apparatus according to an embodiment of this invention employs means for making constant the pressure of a gas introduced into the spaces between a to-be-treated article and the mounting table so that heat transfer between the to-be-treated article and the mounting table can be made stable during the treatment. This allows the temperature of the to-be-treated article to be retained within a predetermined range.

The treatment apparatus according to this embodiment is provided in the mounting table with a plurality of gas inlets for making uniform the pressure between the to-be-treated article and the mounting table over the whole area of the back surface of the wafer. This arrangement prevents the pressure increase only at the gas inlets and permits the pressure between the to-be-treated article and the mounting table to be made substantially uniform, thereby enabling the temperature distribution to be uniform over the whole area of the to-be-treated article.

The treatment apparatus according to this embodiment further has an elastic film made of synthetic resin formed on the surface of the mounting table disposed opposed to the to-be-treated article in order to maintain impedance between the to-be-treated article and the mounting table to a predetermined value. This prevents the occurrence of extraordinary discharge due to impedance variation or the like and thus damages of the to-be-treated article caused by the extraordinary discharge.

## Claims

1. A treating apparatus for treating an article to be treated under a reduced pressure by adjusting the temperature of said article through a heat-transfer medium gas, comprising:
a base member (2) for holding an article (6) to be treated;
means (13) for introducing a heat-transfer medium gas into a gap between said article (6) and said base member (2);
means (17-24) for controlling the amount of said heat-transfer medium gas introduced into said gap to maintain the pressure of said heat-transfer medium gas at a constant value; and
means (8) for pressing a peripheral portion of said article (6) against said base member (2) and holding said article (6),
**characterized** in that
said base member (2) has a face which is disposed opposed to said article (6) and formed with a polyimide-based synthetic resin film (5), which is held on said face by means of an adhesive;
said heat-transfer medium gas is introduced into the gap between said article (6) and said synthetic resin film (5); and
said base member (2) is provided with a plurality of gas inlets (13a - 13d) for retaining uniform pressure in said gap between said article (6) and said film, said inlets (13a - 13d) being provided in the central, the intermediate and the peripheral portion of the base member (2).

2. The treating apparatus according to claim 1,
**characterized** in that
said pressure maintaining means comprises means (17) for controlling an amount of flow of said heat-transfer medium gas, means (19) for detecting said pressure of said heat-transfer medium gas, and means (22, 23) for exhausting said heat-transfer medium gas in response to a detected pressure signal.

3. The treating apparatus according to claim 1,
**characterized** in that
said base member (2) has a uniform-load face disposed opposed to said article (6).

4. The treating apparatus according to claim 1, which is an apparatus selected from the group consisting of an etching apparatus, an ashing apparatus, an ion-implanting apparatus and a sputtering apparatus.

## Patentansprüche

1. Behandlungsvorrichtung zum Behandeln eines zu behandelnden Artikels unter einem reduzierten Druck durch Einstellung der Temperatur des Artikels durch ein Wärmeübertragungsmedium Gas, mit:
einem Grundelement (2) zum Halten eines zu behandelnden Artikels (6);
Mittel (13) zum Einführen eines Wärmeübertragungsmediums Gas in einen Spalt zwischen dem Artikel (6) und dem Grundelement (2);
Mittel (17 bis 24) zum Regeln der Menge des in den Spalt eingeführten Wärmeübertragungsmediums Gas, um den Druck des Wärmeübertragungsmediums Gas auf einem konstanten Wert zu halten; und
Mittel (8) zum Pressen eines Umfangsabschnitts des Artikels (6) gegen das Grundelement (2) und zum Halten des Artikels (6),
dadurch **gekennzeichnet**, daß
das Grundelement (2) eine Fläche besitzt, die dem Artikel (6) gegenüberliegend angeordnet ist und mit einem auf Polyimid basierenden, synthetischen Kunstharzfilm (5) ausgebildet ist, der auf der Fläche mittels eines Klebstoffs gehalten wird;
das Wärmeübertragungsmedium Gas in den Spalt zwischen dem Artikel (6) und dem Kunstharzfilm (5) eingeführt wird; und
das Grundelement (2) mit einer Vielzahl von Gaseinlässen (13a bis 13d) zum Beibehalten eines gleichförmigen Drucks in dem Spalt zwischen dem Artikel (6) und dem Film versehen ist, wobei die Einlässe (13a bis 13d) in dem Mittel-, dem Zwischen- und dem Umfangsabschnitt des Grundelements (2) geschaffen sind.

2. Behandlungsvorrichtung nach Anspruch 1, dadurch gekennzeichnet, daß die Druckhaltemittel Mittel (17) zum Regeln eines Durchflußbetrags des Wärmeübertragungsmediums Gas, Mittel (19) zum Erfassen des Drucks des Wärmeübertragungsmediums Gas und Mittel (22, 23) zum Entleeren des Wärmeübertragungsmediums Gas in Reaktion auf ein erfaßtes Drucksignal umfassen.

3. Behandlungsvorrichtung nach Anspruch 1, dadurch gekennzeichnet, daß das Grundelement (2) eine gleichmässige Lastfläche besitzt, die dem Artikel (6) gegenüberliegend angeordnet ist.

4. Behandlungvorrichtung nach Anspruch 1, die eine Vorrichtung ist, die aus der Gruppe ausgewählt ist, bestehend aus einer Ätzvorrichtung, einer Veraschungsvorrichtung (ashing apparatus), einer Ionenimplantierungsvorrichtung und einer Sputtervorrichtung.

## Revendications

1. Appareil de traitement pour traiter un article devant être traité sous une pression réduite par réglage de la température dudit article au moyen d'un gaz de transfert de chaleur, comprenant:
un élément de support (2) pour supporter un article (6) à traiter;
un moyen (13) pour introduire un gaz de transfert de chaleur dans un intervalle entre ledit article (6) et ledit élément de support (2);
des moyens (17-24) pour régler la quantité dudit gaz de transfert de chaleur introduit dans ledit intervalle afin de maintenir la pression dudit gaz de transfert de chaleur à une valeur constante; et
un moyen (8) pour serrer une partie périphérique dudit article (6) contre ledit élément de support (2) et maintenir en place ledit article (6),
caractérisé en ce que:
ledit élément de support (2) comprend une face qui est disposée en regard dudit article (6) et qui comporte un film (5) de résine synthétique à support de polyimide, ce film étant maintenu sur ladite face au moyen d'un adhésif;
ledit gaz de transfert de chaleur est introduit dans l'intervalle entre ledit article (6) et ledit film (5) de résine synthétique; et
ledit élément de support (2) est muni d'une pluralité d'entrées de gaz (13a - 13d) destinées à maintenir une pression uniforme dans ledit intervalle entre ledit article (6) et ledit film, lesdites entrées (13a - 13d) étant formées dans la partie centrale, la partie intermédiaire et la partie périphérique de l'élément de support (2).

2. Appareil de traitement selon la revendication 1, caractérisé en ce que ledit moyen de maintien de pression comprend un moyen (17) pour régler le débit dudit gaz de transfert de chaleur, un moyen (19) pour détecter ladite pression dudit gaz de transfert de chaleur, et des moyens (22, 23) pour l'échappement dudit gaz de transfert de chaleur en réponse à un signal de pression détecté.

3. Appareil de traitement selon la revendication 1, caractérisé en ce que ledit élément de support (2) comporte une face soumise à une charge uniforme et disposée en regard dudit article (6).

4. Appareil de traitement selon la revendication 1, qui est un appareil sélectionné parmi le groupe comprenant un appareil de gravure, un appareil d'abrasion, un appareil d'implantation d'ions et un appareil de pulvérisation cathodique.
